# EUROPEAN PATENT APPLICATION

(11) **EP 4 152 367 A2**
(43) Date of publication of application: **22.03.2023**
(21) Application number: 22189215.1
(22) Date of filing: 08.08.2022
(51) Int. Cl.: H01L 21/60, H01L 25/065, H01L 23/15

(54) **GLASS CORE WITH CAVITY STRUCTURE FOR HETEROGENEOUS PACKAGING ARCHITECTURE**

(30) Priority: 16.09.2021 US 202117477323
(71) Applicant: INTEL Corporation, Santa Clara, CA 95054 (US)
(72) Inventor: PAITAL, Sameer, Mesa, 85212 (US); LI, Yonggang, Chandler, 85248 (US); DARMAWIKARTA, Kristof Kuwawi, Chandler, 85249 (US); DUAN, Gang, Chandler, 85248 (US); PIETAMBARAM, Srinivas, Chandler, 85297 (US)
(74) Representative: HGF

(57) **Abstract**

A microelectronic assembly is disclosed, comprising: a substrate having a core made of glass; and a first integrated circuit (IC) die and a second IC die coupled to a first side of the substrate. The core comprises a cavity, a third IC die is located within the cavity, and the core further comprises one or more conductive through-glass via (TGV) that facilitates electrical coupling between the first side of the substrate and an opposing second side of the substrate. In some embodiments, the cavity is a blind cavity; in other embodiments, the cavity is a through-hole. In some embodiments, the third IC die merely provides lateral coupling between the first IC die and the second IC die; in other embodiments, the third IC die also provides electrical coupling between the first side and the second side of the substrate with through-silicon vias.

## Description

### TECHNICAL FIELD

The present disclosure relates to techniques, methods, and apparatus directed to glass core with one or more cavity structures for heterogeneous packaging architecture.

### BACKGROUND

Electronic circuits when fabricated on a wafer of semiconductor material, such as silicon, are commonly called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system. Some ICs have specific functionalities, such as memory or processing. Some other ICs have multiple functionalities, such as a system-on-chip (SOC), in which all or most components of a computer or other electronic system are integrated into a single monolithic die.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a simplified cross-sectional view of an example heterogeneous packaging architecture, according to some embodiments of the present disclosure.
FIG. 2 simplified cross-sectional view of another example heterogeneous packaging architecture, according to some embodiments of the present disclosure.
FIG. 3 simplified cross-sectional view of structural details of an example heterogeneous packaging architecture, according to some embodiments of the present disclosure.
FIGS. 4A-4J are simplified cross-sectional views illustrating various manufacturing steps of an example heterogeneous packaging architecture, according to some embodiments of the present disclosure.
FIGS. 5A-5J are simplified cross-sectional views illustrating various manufacturing steps of an example heterogeneous packaging architecture, according to some embodiments of the present disclosure.
FIG. 6 is a cross-sectional view of a device package that may include one or more microelectronic assemblies in accordance with any of the embodiments disclosed herein.
FIG. 7 is a cross-sectional side view of a device assembly that may include one or more microelectronic assemblies in accordance with any of the embodiments disclosed herein.
FIG. 8 is a block diagram of an example computing device that may include one or more microelectronic assemblies in accordance with any of the embodiments disclosed herein.

### DETAILED DESCRIPTION

### Overview

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in a way that limits the broad scope of the present disclosure and its potential applications.

Increasing functionalities required of semiconductor dies in multichip packages and the concomitant need for fine die-to-die interconnections in the face of high cost and low manufacturing device yield due to transistor shrinkage are driving novel packaging approaches such as hyper-chip stacking (with silicon interposer), silicon bridges (*e.g*., Embedded Multi-die Interconnect Bridge (EMIB)) and 2.5D/3D heterogeneous integration. Heterogeneous integration uses a packaging technology in which dissimilar chips with different functions are integrated within the package using lateral connections, as in 2.5-D packaging architecture or through-connections, as in 3-D packaging architecture. Although the designs are quite different between 2.5D and 3D packaging architecture, they are both intended to improve package performance by primarily focusing in two directions: (1) reduced package x, y dimensions (*e.g*., form factor), for example, with chip stacking using thinned chips, and (2) increasing input/output (I/O) density for multichip integration.

Manufacturing yield of these type of packages can be increased with a rigid carrier wafer such as glass based on a temporary bonding and debonding technology. The temporary rigid glass substrate enables handling of thinned chips, and grinding of dielectric materials for revealing lithographically formed plated vias (LIV). Further, the low total thickness variation (TTV) of less than or equal to 10 micrometer associated with glass enables meeting stringent via-to-pad overlay requirements, for example, an average of + 4-sigma of less than or equal to 4 micrometer for fine pitch scaling up to 2/2 micrometer (*i.e*., 2 micrometer line width with 2 micrometer line spacing). However, one of the challenges associated with such temporary bonding and debonding technology is warpage or shrinkage control after removal of the rigid carrier. For example, after the rigid glass carrier is debonded post-first-level interconnect (FLI) bump formation, the substrate is warps due to inbuilt residual stress and coefficient of thermal expansion (CTE) mismatch between various components (*e.g*., silicon CTE is2.6 ppm/°C, Ajinomoto Buildup Film (ABF) CTE is approximately 39 ppm/°C and Cu CTE is 17 ppm/°C). Such warpage or shrinkage in turn can impact backend processes for mid-level interconnect (MLI) bump formation and also assembly processes.

On the other hand, glass-reinforced epoxy matrix laminated with copper cladding has lower stiffness as compared to bulk glass. Hence, such glass-reinforced epoxy matrix structures do not form a rigid backing substrate material and can scale non-uniformly and warp during subsequent dry processes (*e.g*., lithographic exposure, laser drilling, lamination, annealing, etc.) and wet processes (*e.g*., metallization, photoimaging, stripping, etc.) used in typical substrate package manufacturing. These organic cores are hence suitable mainly for those process applications where linear dimensional requirements are relaxed (*e.g*., line scaling of greater than 5/5 micrometer, i.e., 5 micrometer line width and 5 micrometer line spacing, and/or FLI bump pitch scaling of greater than 55 micrometer); they are generally not suitable for high density or hyperscale packaging where less than 30 micrometer bump pitch is desired.

In one aspect of the present disclosure, an example package architecture includes a substrate having a glass core with a cavity structure for heterogeneous integration of disparate IC dies. In example embodiments, TTV of such substrates may be around 2 micrometer to 3 micrometer, thereby enabling suitable 2.5D and 3D packaging architecture. Such rigid glass with cavity structure (*e.g*., blind cavity and through-cavity) may be retained within the substrate (*e.g*., permanently as opposed to temporary carrier wafer processing structures), for example, to maintain TTV across a manufacturing panel or wafer and thereby enable packages for 2.5D and 3D heterogeneous integration. In various embodiments, various processes including laser patterning of glass known in the art may be used to achieve desired results.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are stated in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may comprise substantially monocrystalline semiconductors, such as silicon or germanium, as a base material on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a semiconductor-on-insulator (SOI, e.g., a silicon-on-insulator) structure. In some other embodiments, the base material of one or more of the IC dies may comprise alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (*e.g*., Al, Ga, In), and a second sub-lattice of at least one element of group V of the periodic table (*e.g*., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a non-crystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (*e.g*., base material) upon which IC circuits and structures as described herein may be built falls within the scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of input/output (I/O) functions, arithmetic operations, pipelining of data, etc.).

In another example, the terms "package" and "IC package" are synonymous, as are the terms "die" and "IC die." Note that the terms "chip," "die," and "IC die" are used interchangeably herein.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., metal oxide semiconductor (MOS) FETs (MOSFETs). In general, a FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PCI. In such cases, the term "interconnect" may refer to optical waveguides (*e.g*., structures that guide and confine light waves), including optical fiber, optical splitters, optical combiners, optical couplers, and optical vias.

The term "conductive trace" may be used to describe an electrically conductive element isolated by an insulating material. Within IC dies, such insulating material comprises interlayer low-k dielectric that is provided within the IC die. Within package substrates, and printed circuit boards (PCBs) such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "metallization stack" may be used to refer to a stack of one or more interconnects for providing connectivity to different circuit components of an IC die/chip and/or a package substrate.

In context of a stack of dies coupled to one another or in context of a die coupled to a package substate, the term "interconnect" may also refer to, respectively, die-to-die (DTD) interconnects and die-to-package substrate (DTPS) interconnects.

Although not specifically shown in all of the present illustrations in order to not clutter the drawings, when DTD or DTPS interconnects are described, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the DTD or DTPS interconnects.

In some embodiments, the pitch of the DTD interconnects may be different from the pitch of the DTPS interconnects, although, in other embodiments, these pitches may be substantially the same.

The DTPS interconnects disclosed herein may take any suitable form. In some embodiments, a set of DTPS interconnects may include solder (e.g., solder bumps or balls that are subject to a thermal reflow to form the DTPS interconnects). DTPS interconnects that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of DTPS interconnects may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression.

The DTD interconnects disclosed herein may take any suitable form. In some embodiments, some or all of the DTD interconnects in a microelectronic assembly or an IC package as described herein may be metal-to-metal interconnects (e.g., copper-to-copper interconnects, or plated interconnects). In such embodiments, the conductive contacts on either side of the DTD interconnect may be bonded together (e.g., under elevated pressure and/or temperature) without the use of intervening solder or an anisotropic conductive material. In some metal-to-metal interconnects, a dielectric material (e.g., silicon oxide, silicon nitride, silicon carbide) may be present between the metals bonded together (e.g., between copper pads or posts that provide the associated conductive contacts). In some embodiments, one side of a DTD interconnect may include a metal pillar (e.g., a copper pillar), and the other side of the DTD interconnect may include a metal contact (e.g., a copper contact) recessed in a dielectric. In some embodiments, a metal-to-metal interconnect (e.g., a copper-to-copper interconnect) may include a noble metal (e.g., gold) or a metal whose oxides are conductive (e.g., silver). In some embodiments, a metal-to-metal interconnect may include metal nanostructures (e.g., nanorods) that may have a reduced melting point. Metal-to-metal interconnects may be capable of reliably conducting a higher current than other types of interconnects; for example, some solder interconnects may form brittle intermetallic compounds when current flows, and the maximum current provided through such interconnects may be constrained to mitigate mechanical failure.

In some embodiments, the dies on either side of a set of DTD interconnects may be unpackaged dies.

In some embodiments, the DTD interconnects may include solder. For example, the DTD interconnects may include conductive bumps or pillars (e.g., copper bumps or pillars) attached to the respective conductive contacts by solder. In some embodiments, a thin cap of solder may be used in a metal-to-metal interconnect to accommodate planarity, and this solder may become an intermetallic compound during processing. In some embodiments, the solder used in some or all of the DTD interconnects may have a higher melting point than the solder included in some or all of the DTPS interconnects. For example, when the DTD interconnects in an IC package are formed before the DTPS interconnects are formed, solder-based DTD interconnects may use a higher-temperature solder (e.g., with a melting point above 200 degrees Celsius), while the DTPS interconnects may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth), tin, silver, bismuth, indium, indium and tin, or gallium.

In some embodiments, a set of DTD interconnects may include an anisotropic conductive material, such as any of the materials discussed above for the DTPS interconnects. In some embodiments, the DTD interconnects may be used as data transfer lanes, while the DTPS interconnects may be used for power and ground lines, among others.

In microelectronic assemblies or IC packages as described herein, some or all of the DTD interconnects may have a finer pitch than the DTPS interconnects. In some embodiments, the DTPS interconnects disclosed herein may have a pitch between about 80 microns and 300 microns, while the DTD interconnects disclosed herein may have a pitch between about 7 microns and 100 microns. In some embodiments, the DTD interconnects may have too fine a pitch to couple to the package substrate directly (e.g., too fine to serve as DTPS interconnects). The DTD interconnects may have a smaller pitch than the DTPS interconnects due to the greater similarity of materials in the different dies on either side of a set of DTD interconnects than between a die and a package substrate on either side of a set of DTPS interconnects. In particular, the differences in the material composition of dies and package substrates may result in differential expansion and contraction of the die dies and package substrates due to heat generated during operation (as well as the heat applied during various manufacturing operations). To mitigate damage caused by this differential expansion and contraction (e.g., cracking, solder bridging, etc.), the DTPS interconnects in any of the microelectronic assemblies or IC packages as described herein may be formed larger and farther apart than DTD interconnects, which may experience less thermal stress due to the greater material similarity of the pair of dies on either side of the DTD interconnects.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may comprise the same or different insulating materials. In some embodiments, the levels of underfill may comprise thermoset epoxies with silicon oxide particles; in some embodiments, the levels of underfill may comprise any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photo-imageable polymers. In some embodiments, solder resist may be non-photo-imageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

For convenience, if a collection of drawings designated with different letters are present (e.g., FIGS. 10A-10C), such a collection may be referred to herein without the letters (e.g., as "FIG. 10"). Similarly, if a collection of reference numerals designated with different letters are present (e.g., 110a-110e), such a collection may be referred to herein without the letters (e.g., as "110").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

### Example embodiments

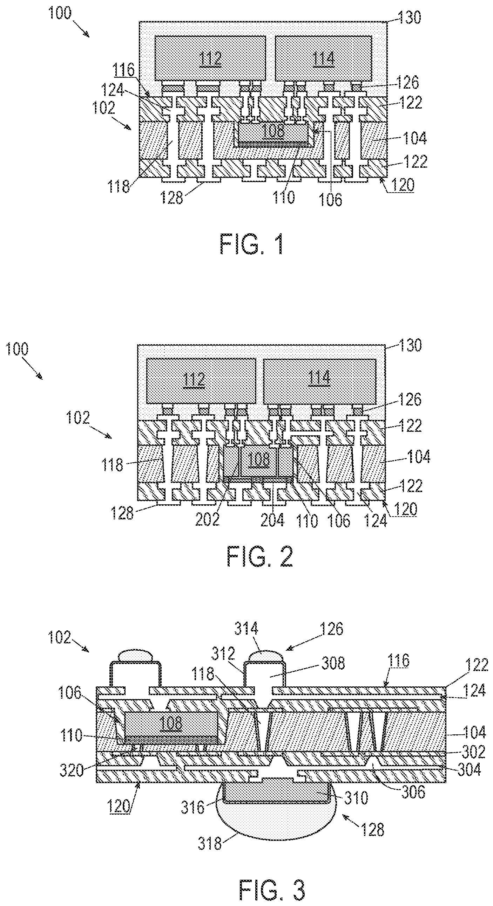

FIG. 1 is a schematic cross-sectional illustration of a portion of a microelectronic assembly 100, according to some embodiments of the present disclosure. An example embodiment comprises a substrate 102 having a core 104. In various embodiments, a thickness of core 104 may be between 100 micrometer and 1500 micrometer. Core 104 comprises bulk transparent glass, which is different from fiberglass typically used in reinforced epoxy cores for package substrates or motherboards. Moreover, in various embodiments, the glass of core 104 is not explicitly combined with any organic material but rather comprises any type of bulk amorphous or polycrystalline transparent, opaque, or semi-transparent glass, including fused silica, borosilicate glass, soda-lime glass, ceramic glass, etc.

In the example embodiment shown, core 104 comprises one or more cavity 106 in which is located an IC die 108 attached to core 104 with a suitable adhesive 110. Note that although organic substrates with cavities are known in the art, they differ from substrate 102 of the present disclosure in not having a core comprised of glass. The presence of glass instead of an organic core, such as fiberglass reinforced epoxy or prepreg, allows finer line widths and line spacings in substrate 102 because of the high planarity of the glass panel comprising core 104. Although conceptually simple, it is not easy or obvious to replace organic cores of substrates known in the art with a glass core as described herein because of handling challenges and processing differences on any typical manufacturing floor between panels comprising organic material and panels comprising glass. In addition, while glass substrates are known in the art, such substrates do not comprise cavities configured to seat IC dies as described herein. It is also not easy or obvious to form cavities in such currently known glass substrates because of the additional processing steps required to form the cavities and place IC dies accurately therein.

In various embodiments, adhesive 110 may comprise an industry-standard die attach material, such as liquid epoxy or polyimide film. In various embodiments, cavity 106 may comprise a blind cavity or a through-hole cavity, which may be used for correspondingly different types of IC die 108 inserted therein. For example, IC die 108 located in blind cavity 106 as shown may function as a bridge die providing high density electrical silicon-level interconnection between lateral components, such as IC die 112 and IC die 114, located on one side 116 of substrate 102, as in a 2.5D packaging architecture. Besides the lack of need for electrical coupling through IC die 108 (e.g., between opposing sides), the dimensions of IC die 108 in relation to substrate 102 may be such that a blind cavity is sufficient; for example, IC die 108 may be thinner than substrate 102. In some embodiments, IC die 108 may comprise only passive elements, for example, conductive traces and vias with resistors and capacitors fabricated in metallization layers with inter-layer dielectric (ILD) over a silicon substrate; in other embodiments, IC die 108 may comprise active elements also, including transistors, diodes, and the like. The choice of using active elements in IC die 108 may vary depending on desired functionalities, performance, cost, and manufacturing considerations of microelectronic assembly 100. IC die 108 may be any suitable IC fabricated on a semiconductor substrate within the broad scope of the present disclosure.

In various embodiments, IC die 112 and IC die 114 may include, or be a part of, one or more of a central processing unit (CPU), a memory device, e.g., a high-bandwidth memory device, a logic circuit, input/output circuitry, a transceiver such as a field programmable gate array transceiver, a gate array logic such as a field programmable gate array logic, of a power delivery circuitry, a III-V or a III-N device such as a III-N or III-N amplifier (*e.g*., GaN amplifier), Peripheral Component Interconnect Express (PCIe) circuitry, Double Data Rate (DDR) transfer circuitry, or other electronic components known in the art. In some embodiments, IC die 112 and IC die 114 may comprise different functionalities. As used herein, the term "functionality" with reference to an IC die refers to one or more function (*e.g*., capability, task, operation, action, instruction execution, etc.) that the IC die in question can perform. For example, IC die 112 may be a CPU and IC die 114 may be a Graphics Processing Unit (GPU) or memory. In other embodiments, IC die 112 and IC die 114 may comprise the same or similar functionalities. For example, IC die 112 and IC die 114 may each comprise memory.

One or more through-glass via (TGV) 118 in core 104 may enable power, ground and signal connectivity to components located on either side of substrate 102, for example, between IC die 112, 114 on side 116 and a printed circuit board (PCB) or another substrate (not shown) located on opposite side 120. TGV 118 is shown as having straight, parallel edges; however, in various embodiments, the edges may be tapered and/or have other irregularities depending on the processing conditions for generating TGV 118.

A dielectric 122 may encapsulate core 104 on either side, filling in cavity 106 as appropriate, including any spaces around die 108 in cavity 106. In various embodiments, dielectric 122 may comprise ABF, benzocyclobutene (BCB), cyclotene, polyimide, epoxy/phenol, acrylic, and/or polybenzoxazole (PBO). In other embodiments, dielectric 122 may comprise bismaleimide-triazine (BT) resin, organic dielectrics with inorganic fillers or low-k and ultra low-k dielectric (*e.g*., carbon-doped dielectrics, fluorine-doped dielectrics, porous dielectrics, and organic polymeric dielectrics). Conductive traces 124, including vias, planes and pads, may be provided on either side of core 104 in dielectric 122 using any suitable conductive material, such as copper. In various embodiments, dielectric 122 and conductive traces 124 may be formed as alternating layers with conductive vias through dielectric 122 providing electrical coupling between metal layers. Dielectric 122 and conductive traces 124 on either side of core 104 thus differentiate substrate 102 from some glass substrates known in the art, in which such structures are not used, and instead, metallization is patterned directly on the glass itself.

In various embodiments, a size of substrate 102 (*e.g*., thickness and footprint) may vary according to a number of interconnections required laterally between IC die 112 and IC die 114 as also with a number of IC dies coupled to substrate 102. For example, larger number of interconnections between IC die 112 and IC die 114 may lead to greater number of dielectric layers and metal layers constituting dielectric 122 and conductive traces 124 in substrate 102. In another example, greater number of ICs coupled laterally on side 116 of substrate 102 may require a larger footprint of substrate 102 to accommodate all of them.

Conductive pads on exposed sides of dielectric 122 may enable coupling to external interconnects as appropriate. In various embodiments, IC dies 112 and 114 may be electrically and mechanically coupled to substrate 102 on side 116 with FLI 126. Interconnects on side 120 of substrate 102 may comprise MLI 128. Note that in the figure, the form (*e.g*., shape, structure, etc.) of MLI 128 is not shown; only the conductive contacts (*e.g*., bond pads) to which MLI 128 is attached is indicated therein. An underfill or other material (not shown) that provides electrical insulation and mechanical stability and reliability may be optionally provided between substrate 102 and components coupled thereto. A mold compound 130 may encapsulate IC dies 112 and 114 as appropriate on side 116 of substrate 102. In some embodiments (not shown) other components, such as heat sinks may be coupled to microelectronic assembly 110 based on particular needs.

In some embodiments, the IC dies (*e.g*., 108, 112, 114) in microelectronic assembly 100 may comprise the materials discussed above with regard to IC dies in general. In various embodiments, FLI 126 and MLI 128 may comprise the same or different types of DTD interconnects as described above. In embodiments wherein substrate 102 is coupled directly to a PCB and functions as a conventional package substrate rather than an interposer or a patch substrate, MLI 128 may be known as second-level interconnects (SLI), comprising DTPS interconnects as described above. Note that according to currently accepted terminology among those with ordinary skill in the art, FLI refers to the interconnection between the IC dies and other components; MLI refers to the interconnection between the interposer or patch substrate and the package substrate; and SLI refers to the interconnection between the package substrate and the PCB. In many embodiments, MLI 128 may be formed with a looser pitch and/or coarser design rules or critical dimensions than FLI 126 between IC die 104 and substrate 102. In various embodiments, the pitch of MLI 128 may be larger than or equal to the pitch of FLI 126. In embodiments where the pitch of MLI 128 is larger than the pitch of FLI 126, substrate 102 may also function as a redistribution layer (RDL), enabling fanning out interconnections from a finer pitch to a coarser pitch, thereby allowing cheaper package substrates or interposers manufactured with less advanced technologies to be coupled thereto.

Note that in FIG. 1 and in subsequent figures, the FLI are shown as aligned at the respective interfaces merely for ease of illustration; in actuality, some or all of them may be misaligned. In addition, there may be other components, such as bond pads, landing pads, metallization, etc. present in the assembly that are not shown in the figures to prevent cluttering. Note that FIG. 1 is intended to show relative arrangements of the components within their assemblies, and that, in general, such assemblies may include other components that are not illustrated (*e.g*., various interfacial layers or various other components related to optical functionality, electrical connectivity, or thermal mitigation). For example, in some further embodiments, the assembly as shown in FIG. 1 may include more dies along with other electrical components. Additionally, although some components of the assemblies are illustrated in FIG. 1 as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

FIG. 2 is a simplified cross-sectional view of microelectronic assembly 100 according to another example embodiment of the present disclosure. Cavity 106 in the example embodiment is a through-hole, and IC die 108 is attached to dielectric 122 in cavity 106 with die attach adhesive 110. IC die 108 in the example shown comprises one or more through-silicon via (TSV) 202 enabling power, ground and signal connectivity to components located on either side of substrate 102 as in 3D packaging architecture, in addition to high density electrical interconnection between lateral components located on the same side of substrate 102 as in 2.5D packaging architecture. TSV 202 may be electrically coupled further to vias in dielectric 122 with a suitable interconnect 204. In some embodiments, interconnect 204 may comprise solder-based materials; in other embodiments, interconnect 204 may comprise other kinds of conductive materials. In some embodiments, interconnect 204 may merely comprise conductive metal pads. Note that TGV 118 is shown in the figure as tapered rather than straight, although they may be straight in other embodiments, depending on the process used to fabricate them.

FIG. 3 is a simplified cross-sectional view of details of substrate 102 in an example package architecture according to various embodiments. Core 104 comprises cavity 106 configured to seat IC die 108 with adhesive 110. Although a blind cavity is shown in the figure, cavity 106 can alternatively extend through a thickness of core 104 to form a through-hole. Further, IC die 108 may include metallization layers in ILD (not shown) to enable lateral electrical coupling along its length or width and TSV 202 (not shown) for electrical coupling across its thickness. In some embodiments, IC die 108 may comprise active elements; in other embodiments, IC die 108 may comprise only passive elements without any active circuitry. A seed layer 302 comprising titanium and copper may line TGV 118 and core 104. In various embodiments, seed layer 302 may function as a catalyst for electrolytic deposition of copper, for example, in TGV 118. Conductive traces 124 can include seed layer 302 suitably patterned over core 104, one or more layer 304 of metallization on one or more layer of dielectric 122, via 306 comprising gold plugs or copper vias through the one or more layer of dielectric 122, one or more conductive contact 308 on side 116 of substrate 102 and one or more conductive contact 310 on side 120 of substrate 102.

In the example embodiment shown, conductive contact 308 comprises a copper pillar coated with a protective layer 312 comprising, for example, gold, and a solder cap 314. In the bonded state (not shown), solder cap 314 couples with corresponding bond pads or other conductive contacts on, for example, IC die 112 (or 114), forming FLI 126 comprising hybrid direct bonds providing mechanical and electrical coupling between substrate 102 and the bonded component. In other embodiments, conductive contact 308 may comprise a bond pad suitable for a flip-chip bump, in which case, solder cap 314 may comprise the flip-chip bump. In yet other embodiments, conductive contact 308 may comprise anisotropic adhesive or other structures as discussed above.

In the example embodiment shown, conductive contact 310 comprises electroless nickel (*e.g*., nickel alloy with phosphorus) with another protective layer 316 of immersion gold (*e.g*., alloy of nickel and gold) and a solder ball 318, for example, a flip-chip bump. In the bonded state, solder ball 318 couples with corresponding bond pads or other conductive contacts on, for example, a motherboard or another substrate or an interposer (not shown), forming MLI 128 comprising flip-chip connections, providing electrical and mechanical coupling between substrate 102 and the bonded component.

In the example embodiment shown, one or more TGV 320 may provide electrical coupling between IC die 108 in cavity 106 and surface 120 of substrate 102. In such embodiments, IC die 108 may comprise TSVs (not shown) such that electrical coupling is facilitated between surfaces 116 and 120 through IC die 108.

In various embodiments, any of the features discussed with reference to any of FIGS. 1-3 herein may be combined with any other features to form a package with one or more ICs as described herein, for example, to form a modified microelectronic assembly 100. Some such combinations are described above, but, in various embodiments, further combinations and modifications are possible.

### Example methods

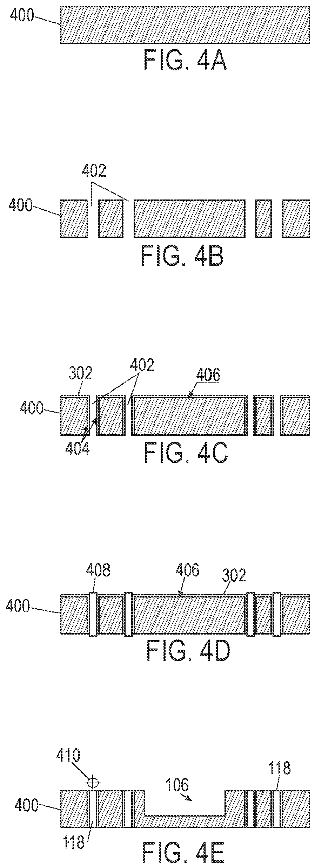

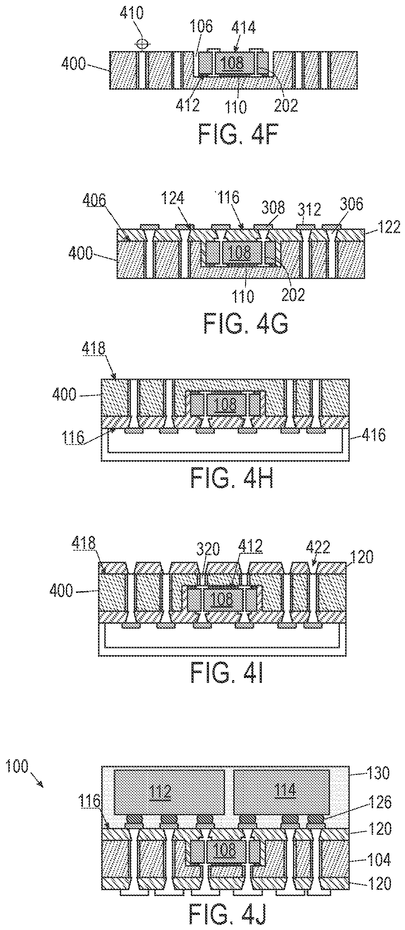

FIGS. 4A-4J are schematic cross-sectional illustrations of various stages of manufacture of microelectronic assembly 100 comprising a blind cavity 106, according to some embodiments of the present disclosure. The process may start with a blank glass panel (or wafer) 400 as shown in FIG. 4A. In various embodiments, panel 400 may comprise an industry-standard panel approximately 510×515 millimeter in footprint size or a wafer of approximately 200-300 mm diameter with thickness varying according to the substrate thickness desired, for example, between 50 micrometer to 1500 micrometer. Panel 400 with any other size may also be used within the broad scope of the embodiments. The process steps to form the configuration shown in FIG. 4B, in which through-holes 402 are created in panel 400. In some embodiments, through-holes 402 may be created using laser induced direct etching (LIDE). In various embodiments, the LIDE process may comprise two steps: in the first step, the glass of panel 400 is locally modified by laser pulses according to a desired layout, for example, via pattern of the through-holes 402; in the second step, the modified areas of the glass are removed by wet chemical etching, for example, with hydrofluoric acid, which removes the modified material more rapidly than the unmodified material. The LIDE process enables via formation at very high density and very small size, allowing finer pitch and/or line width/spacing, for example, 2/2 micrometer line width/spacing.

The process steps to form the configuration shown in FIG. 4C, in which seed layer 302, comprising titanium and copper in some embodiments, is sputtered (or otherwise deposited) on panel 400 along sidewalls 404 of through-holes 402 and on a surface 406 of panel 400. In various embodiments, other processes such as physical vapor deposition (PVD) of copper or silver ink deposition may also be used suitably. The process steps to form the configuration shown in FIG. 4D, in which conductive metal 408, such as copper, is deposited, for example, using a wet electroplating process, to fill through-holes 402. The process steps to form the configuration shown in FIG. 4E, in which surface 406 of panel 400 is planarized after copper plating to remove any plating overburden and complete TGV 118. The planarization process may also remove any excess or undesired seed layer 302 on surface 406 of panel 400. In some embodiments, the planarization process may be performed after etching seed layer 302 according to a trace pattern. The LIDE process is then performed once again to generate cavity 106. In various embodiments, one or more of TGV 118 may be used as a fiducial mark 410 to align cavity 106 appropriately before the LIDE process is performed.

The process steps to form the configuration shown in FIG. 4F, after attaching IC die 108. Fiducial mark 410 may be used to align IC die 108 appropriately in cavity 106. In some embodiments, adhesive 110 may be applied on a side 412 of IC die 108, which may thereafter be placed into cavity 106 with side 412 of IC die 108 facing the bottom of cavity 106. In the example embodiment shown, IC die 108 may comprise one or more TSV 202 that enables electrical coupling between side 412 and opposite side 414 of IC die 108. Note that although not shown so as not to clutter the drawing, IC die 108 may also comprise a metallization stack with ILD to enable lateral electrical coupling between components coupled to side 414 of IC die 108.

The process steps to form the configuration shown in FIG. 4G, after deposition of dielectric 122 and conductive traces 124. In the example shown, conductive traces 124 comprise one or more via 306 and one or more conductive contact 308 with protective coating 312. In various embodiments, dielectric 122 may comprise one or more types of materials, and may include one or more layers thereof. In one embodiment, IC die 108 may be encapsulated with dielectric 122, for example, using vacuum forming to fill in any space around IC die 108 in cavity 106. In an example embodiment, a solder resist film may be used to encapsulate surface 406 of panel 400 and side 414 of IC die 108. The solder resist film may then be vacuum sealed or pressed thereto, such that it conforms to all surfaces of panel 400, including sidewalls of cavity 106 to fill any space around IC die 108 therein. Subsequently, other materials, such as ABF, may be deposited thereon followed by alternating layers of patterned metal and ABF with via drilling therebetween to complete fabricating dielectric 122 and conductive traces 124. In some embodiments, an ABF layer rather than solder resist layer, may be used for encapsulation, followed by via drilling and conductive routing on top of ABF, further followed by solder resist lamination to complete fabricating dielectric 122 and conductive traces 124. In some embodiments, laser drilling or lithographic etching processes are used to generate via 306 followed by surface finish processes (*e.g*., solder resist lamination, metallization, etc.) to form conductive contact 308.

The process steps to form the configuration shown in FIG. 4H, after attaching a protective cap 416 to surface 116 and flipping panel 400 so that surface 418 opposite to side 116 is exposed for further processing. In various embodiments, protective cap 416 may be attached by any suitable means, including adhesives. The process steps to form the configuration shown in FIG. 41, in which dielectric 122 is deposited on surface 418 of panel 400 after one or more TGV 320 has been formed in panel 400. In some embodiments, the LIDE process is used to generate one or more vias through panel 400 that exposes conductive contact pads on side 412 of IC die 108. Note that in embodiments in which IC die 108 does not have any TSV 202, TGV 320 may be unnecessary; hence, this process step may be skipped in such embodiments. Subsequently, sputter-depositing a seed layer, followed by electrodeposition of copper in the vias enables formation of TGV 320 that provides electrical coupling between IC die 108 in blind cavity 106 and components (not shown) that eventually would be connected proximate to surface 418 of panel 400.

In various embodiments in which dielectric 122 comprises solder resist, dielectric 122 may be laminated on surface 418 as a film and then patterned to form vias 422. In embodiments in which dielectric 122 on surface 418 comprises other materials, any suitable deposition process as is known in the art may be used followed by via formation suitably. For example, dielectric 122 may be deposited in liquid form and then cured by heat or ultraviolet radiation. In another example, a semi-additive process (SAP) may be used to complete deposition of dielectric 122 and conductive traces 124 (not shown) on surface 418 of panel 400. In some embodiments, dielectric 122 deposited in this process may comprise ABF or other suitable material. In yet other embodiments, various other processes may be used to deposit dielectric 122 suitably, depending on the material deposited, its structure, state, etc. The material may thereafter be patterned suitably, and conductive metal electrodeposited thereon to complete forming conductive traces 124, comprising vias, traces, planes, and conductive contacts over surface 418 of panel 400.

The process thereafter steps to form the configuration shown in FIG. 4J, after protective cap removal, panel flip and die assembly. In various embodiments, protective cap 416 may be removed and panel 400 flipped so that side 116 is exposed for further processing. IC dies 112 and 114 may be coupled to side 116 with FLI 126. Mold 130 may be deposited on side 116 to encapsulate IC dies 112 and 114 appropriately and the assembly diced to generate microelectronic assembly 100, wherein individual pieces of panel 400 are embedded in substrate 102 as core 104.

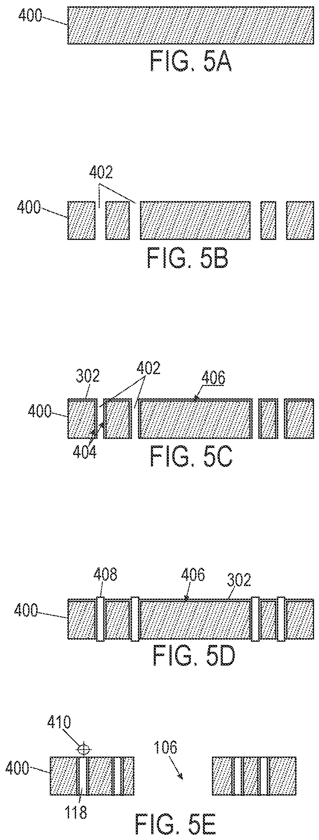

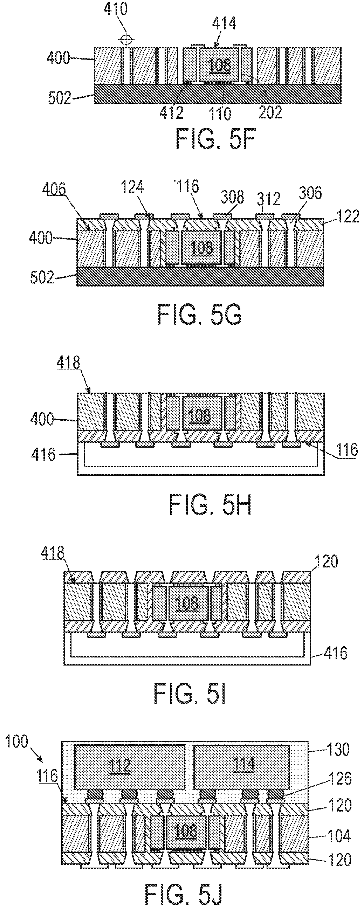

FIGS. 5A-5J are schematic cross-sectional illustrations of various stages of manufacture of microelectronic assembly 100 comprising cavity 106 as a through-cavity, according to some embodiments of the present disclosure. The process may start with a blank glass panel (or wafer) 400 as shown in FIG. 5A. In various embodiments, panel 400 may comprise an industry-standard panel approximately 510×515 millimeter in footprint size or a wafer of approximately 200-300 mm diameter with thickness varying according to the substrate thickness desired, for example, between 50 micrometer to 1500 micrometer. Panel 400 with any other size may also be used within the broad scope of the embodiments. The process then steps to form the configuration shown in FIG. 5B, in which through-holes 402 are created in panel 400. In some embodiments, through-holes 402 may be created using the LIDE process. The sensitized glass is then etched with hydrofluoric acid to remove material, thereby forming the desired pattern of through-holes 402 in panel 400. The LIDE process enables via formation at very high density and very small size, allowing finer pitch and/or line width/spacing, for example, 2/2 micrometer line width/spacing.

The process thereafter steps to form the configuration shown in FIG. 5C, in which seed layer 302, comprising titanium and copper in some embodiments, is sputtered (or otherwise deposited) on panel 400 along sidewalls 404 of through-holes 402 and on a surface 406 of panel 400. In various embodiments, other processes such as PVD of copper or silver ink deposition may also be used suitably. The process thereafter steps to generate the configuration shown in FIG. 5D, in which conductive metal 408, such as copper, is deposited, for example, using a wet electroplating process, to fill through-holes 402. The process steps to form the configuration shown in FIG. 5E, in which surface 406 of panel 400 is planarized after copper plating to remove any plating overburden and complete TGV 118. The planarization process may also remove any excess or undesired seed layer 302 on surface 406 of panel 400. In some embodiments, the planarization process may be performed after etching seed layer 302 according to a trace pattern. The LIDE process is then performed once again to generate through-cavity 106. In various embodiments, one or more of TGV 118 may be used as fiducial mark 410 to align cavity 106 appropriately before the LIDE process is performed.

The process thereafter steps to form the configuration shown in FIG. 5F. Panel 400 is attached to a temporary carrier 502 using any suitable attachment means (not shown), for example, adhesive tape. In various embodiments, carrier 502 may comprise any suitably stiff material, such as metal (*e.g*., copper panel), silicon, or ceramic. Thereafter, IC die 108 comprising TSV 202 is attached to temporary carrier 502 with adhesive 110, using fiducial mark 410 to align IC die 108 appropriately within through-cavity 106. TSV 202 enables electrical coupling between side 412 and opposite side 414 of IC die 108. In some embodiments, adhesive 110 may be applied on side 412 of IC die 108, which may thereafter be placed into cavity 106 with side 412 of IC die 108 facing carrier 502. Note that although not shown so as not to clutter the drawing, IC die 108 may also comprise a metallization stack with ILD to enable lateral electrical coupling between components coupled to side 414 of IC die 108.

The process steps to form the configuration shown in FIG. 5G, after deposition of dielectric 122 and conductive traces 124. In the example shown, conductive traces 124 comprise one or more via 306 and one or more conductive contact 308 with protective coating 312. In various embodiments, dielectric 122 may comprise one or more types of materials, and may include one or more layers thereof. In one embodiment, a layer of dielectric 122 comprising a solder resist film may be used to encapsulate surface 406 of panel 400 and side 414 of IC die 108. The solder resist film may then be vacuum sealed or pressed thereto, such that it conforms to all surfaces of panel 400, including sidewalls of cavity 106 to fill any space around IC die 108 therein. Subsequently, other materials, such as ABF, may be deposited thereon followed by alternating layers of patterned metal and ABF with via drilling therebetween to complete fabricating dielectric 122 and conductive traces 124. In some embodiments, an ABF layer rather than solder resist layer, may be used for encapsulation, followed by via drilling and conductive routing on top of ABF, further followed by solder resist lamination to complete fabricating dielectric 122 and conductive traces 124. In some embodiments, laser drilling or lithographic etching processes are used to generate via 306 followed by surface finish processes (*e.g*., solder resist lamination, metallization, etc.) to form conductive contact 308.

The process steps to form the configuration shown in FIG. 5H, after attaching a protective cap 416 to surface 116, flipping panel 400, and detaching carrier 502 (*e.g*., by mechanical peeling) so that surface 418 opposite to side 116 is exposed for further processing. In various embodiments, protective cap 416 may be attached by any suitable means, including adhesives. The process steps to form the configuration shown in FIG. 51, in which dielectric 122 is deposited on exposed surface 418 of panel 400. In various embodiments in which dielectric 122 comprises solder resist, it may be laminated on surface 418 as a film and then patterned to form vias 422. In embodiments in which dielectric 122 on surface 418 comprises other materials, any suitable deposition process as is known in the art may be used followed by via formation suitably. For example, dielectric 122 may be deposited in liquid form and then cured by heat or ultraviolet radiation. In another example, a SAP may be used to complete deposition of dielectric 122 and conductive traces 124 (not shown) on surface 418 of panel 400. In some embodiments, dielectric 122 deposited in this process may comprise ABF or other suitable material. In yet other embodiments, various other processes may be used to deposit dielectric 122 suitably, depending on the material deposited, its structure, state, etc. The material may thereafter be patterned suitably, and conductive metal electrodeposited thereon to complete forming conductive traces 124, comprising vias, traces, planes, and conductive contacts over surface 418 of panel 400.

The process thereafter steps to form the configuration shown in FIG. 5J, after protective cap removal, panel flip and die assembly. In various embodiments, protective cap 416 may be removed and panel 400 flipped so that side 116 is exposed for further processing. IC dies 112 and 114 may be coupled to side 116 with FLI 126. Mold 130 may be deposited on side 116 to encapsulate IC dies 112 and 114 appropriately and the assembly diced to generate microelectronic assembly 100, wherein individual pieces of panel 400 are embedded in substrate 102 as core 104.

Although FIGS. 4A-4J and FIGS. 5A-5J illustrate various operations performed in a particular order, this is simply illustrative, and the operations discussed herein may be reordered and/or repeated as suitable. For example, one or more operations may be performed in parallel to manufacture multiple microelectronic assemblies substantially simultaneously. In another example, the operations may be performed in a different order to reflect the structure of a particular microelectronic assembly. Numerous other variations are also possible to achieve the desired structure of microelectronic assembly 100. Further, additional processes which are not illustrated may also be performed without departing from the scope of the present disclosure. For example, the operations may include various cleaning operations, surface planarization operations (*e.g*., using CMP), operations for surface roughening, operations to include barrier and/or adhesion layers as desired, and/or operations for incorporating packages as described herein in, or with, an IC die, a computing device, or any desired structure or device. Also, various ones of the operations discussed herein with respect to FIGS. 4A-4J and FIGS. 5A-5J may be modified in accordance with the present disclosure to fabricate others of microelectronic assembly 100 disclosed herein.

### Example devices and components

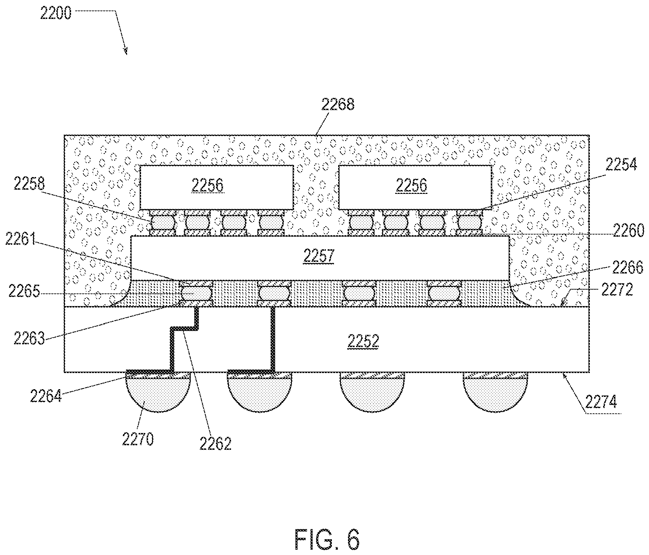

The packages disclosed herein, *e.g*., any of the embodiments shown in FIGS. 1-5 or any further embodiments described herein, may be included in any suitable electronic component. FIGS. 6-8 illustrate various examples of packages, assemblies, and devices that may be used with or include any of the IC packages as disclosed herein.

FIG. 6 is a side, cross-sectional view of an example IC package 2200 that may include microelectronic assemblies in accordance with any of the embodiments disclosed herein. In some embodiments, the IC package 2200 may be a system-in-package (SiP).

As shown in FIG. 6, package support 2252 may be formed of an insulator (*e.g*., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias, *e.g*., as discussed above with reference to FIG. 1.

Package support 2252 may include conductive contacts 2263 that are coupled to conductive pathway 2262 through package support 2252, allowing circuitry within dies 2256 and/or interposer 2257 to electrically couple to various ones of conductive contacts 2264 (or to other devices included in package support 2252, not shown).

IC package 2200 may include interposer 2257 coupled to package support 2252 via conductive contacts 2261 of interposer 2257, FLI 2265, and conductive contacts 2263 of package support 2252. FLI 2265 illustrated in FIG. 6 are solder bumps, but any suitable FLI 2265 may be used, such as solder bumps, solder posts, or bond wires.

IC package 2200 may include one or more dies 2256 coupled to interposer 2257 via conductive contacts 2254 of dies 2256, FLI 2258, and conductive contacts 2260 of interposer 2257. In various embodiments, interposer 2257 may include core 104 comprising glass as described herein. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). FLI 2258 illustrated in FIG. 6 are solder bumps, but any suitable FLI 2258 may be used, such as solder bumps, solder posts, or bond wires. As used herein, a "conductive contact" may refer to a portion of electrically conductive material (*e.g*., metal) serving as an interface between different components; conductive contacts may be recessed in, flush with, or extending away from a surface of a component, and may take any suitable form (*e.g*., a conductive pad or socket).

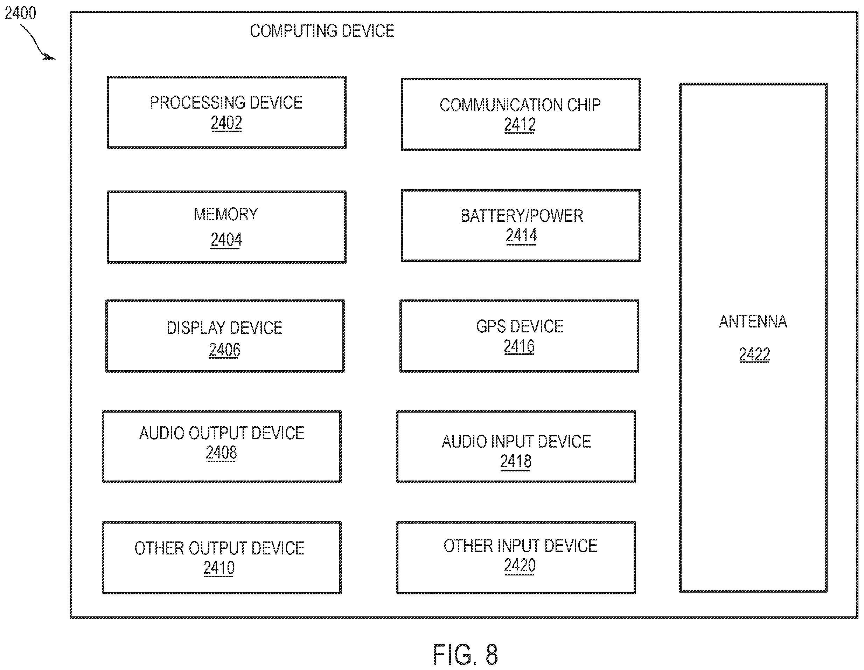

In some embodiments, underfill material 2266 may be disposed between package support 2252 and interposer 2257 around FLI 2265, and mold 2268 may be disposed around dies 2256 and interposer 2257 and in contact with package support 2252. In some embodiments, underfill material 2266 may be the same as mold 2268. Example materials that may be used for underfill material 2266 and mold 2268 are epoxies as suitable. SLI 2270 may be coupled to conductive contacts 2264. SLI 2270 illustrated in FIG. 6 are solder balls (*e.g*., for a ball grid array (BGA) arrangement), but any suitable SLI 2270 may be used (*e.g*., pins in a pin grid array arrangement or lands in a land grid array arrangement). SLI 2270 may be used to couple IC package 2200 to another component, such as a circuit board (*e.g*., a motherboard), an interposer, or another IC package, as known in the art and as discussed below with reference to FIG. 8.

In embodiments in which IC package 2200 includes multiple dies 2256, IC package 2200 may be referred to as a multichip package (MCP). Dies 2256 may include circuitry to perform any desired functionality. For example, besides one or more of dies 2256 comprising components of IC dies 112 or 114 as described herein, one or more of dies 2256 may be logic dies (*e.g*., silicon-based dies), one or more of dies 2256 may be memory dies (*e.g*., high-bandwidth memory), etc. In some embodiments, at least some of dies 2256 may not include components of IC dies 112 or 114 as described herein.

Although IC package 2200 illustrated in FIG. 6 is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package support 2252, or on either face of interposer 2257. More generally, IC package 2200 may include any other active or passive components known in the art.

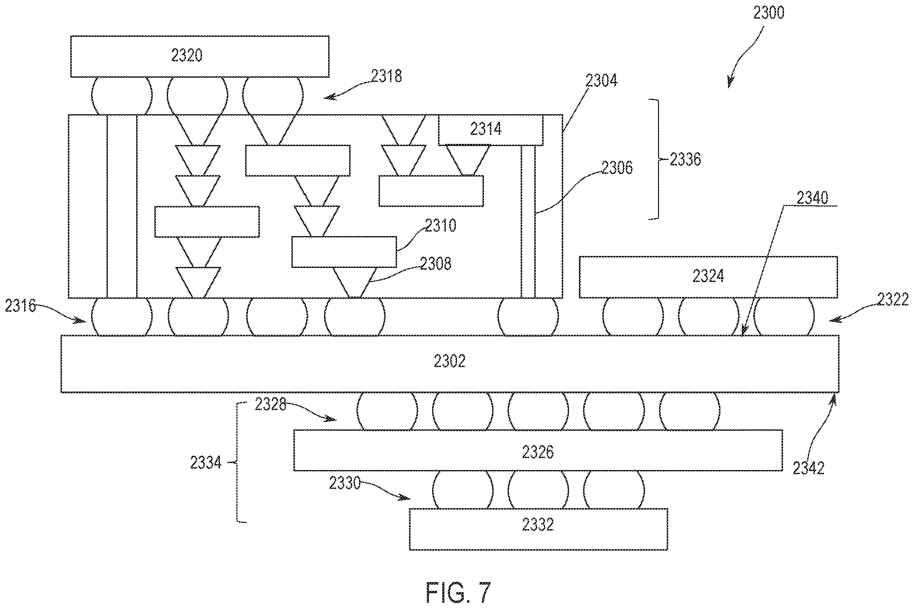

FIG. 7 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, *e.g*., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; *e.g*., any of the IC packages discussed below with reference to IC device assembly 2300 may take the form of any of the embodiments of IC package 2200 discussed above with reference to FIG. 6.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package support.

FIG. 7 illustrates that, in some embodiments, IC device assembly 2300 may include a package-on-interposer structure 2336 coupled to first face 2340 of circuit board 2302 by coupling components 2316. Although not shown so as not to clutter the drawing, package-on-interposer structure 2336 may comprise a glass core, such as core 104 in some embodiments. In other embodiments, package-on-interposer structure 2336 may not comprise any glass core. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. In some embodiments, IC package 2320 may comprise microelectronic assembly 100, including substrate 102 with core 104 having cavity 106, and other components as described herein, which are not shown so as not to clutter the drawing. Coupling components 2318 may take any suitable form depending on desired functionalities, such as the forms discussed above with reference to coupling components 2316. In some embodiments, IC package 2320 may be or include IC package 2200, *e.g*., as described above with reference to FIG. 6.

Although a single IC package 2320 is shown in FIG. 7, multiple IC packages may be coupled to interposer 2304; indeed, additional interposers may be coupled to interposer 2304. Interposer 2304 may provide an intervening package support used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in FIG. 7, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including TSVs 2306. Interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 8 is a block diagram of an example computing device 2400 that may include one or more components having one or more IC packages in accordance with any of the embodiments disclosed herein. For example, any suitable ones of the components of computing device 2400 may include microelectronic assembly 100 including substrate 102 having core 104 comprising glass in accordance with any of the embodiments disclosed herein. In another example, any one or more of the components of computing device 2400 may include any embodiments of IC package 2200 (*e.g.*, as shown in FIG. 6). In yet another example, any one or more of the components of computing device 2400 may include an IC device assembly 2300 (*e.g.*, as shown in FIG. 7).

A number of components are illustrated in FIG. 8 as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single SOC die.

Additionally, in various embodiments, computing device 2400 may not include one or more of the components illustrated in FIG. 8, but computing device 2400 may include interface circuitry for coupling to the one or more components. For example, computing device 2400 may not include a display device 2406, but may include display device interface circuitry (*e.g*., a connector and driver circuitry) to which display device 2406 may be coupled. In another set of examples, computing device 2400 may not include an audio input device 2418 or an audio output device 2408, but may include audio input or output device interface circuitry (*e.g*., connectors and supporting circuitry) to which audio input device 2418 or audio output device 2408 may be coupled.

Computing device 2400 may include a processing device 2402 (*e.g*., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more digital signal processors (DSPs), ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (*e.g*., dynamic random access memory (DRAM)), nonvolatile memory (*e.g*., read-only memory (ROM)), flash memory, solid state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (*e.g*., one or more communication chips; note that the terms "chip," "die," and "IC die" are used interchangeably herein). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including Institute for Electrical and Electronic Engineers (IEEE) standards including Wi-Fi (IEEE 802.11 family), IEEE 802.16 standards (*e.g*., IEEE 802.16-2005 Amendment), Long-Term Evolution (LTE) project along with any amendments, updates, and/or revisions (*e.g*., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives of it, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (*e.g*., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (*e.g*., batteries or capacitors) and/or circuitry for coupling components of computing device 2400 to an energy source separate from computing device 2400 (*e.g*., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (*e.g*., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (*e.g*., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The following paragraphs provide various examples of the embodiments disclosed herein.
Example 1 provides a substrate (*e.g*., 102 of FIG. 1) for a microelectronic assembly (*e.g.,* 100) comprising: a core (*e.g*., 104) including glass, and dielectric and conductive traces on either side of the core. The core includes a cavity (*e.g*., 106) configured to seat an IC die (*e.g*., 108), and the core further includes one or more conductive TGV (*e.g*., 118) through the core.
Example 2 provides the substrate of example 1, in which the cavity is a blind cavity.
Example 3 provides the substrate of example 2, further comprising another TGV (*e.g*., 320) through the core between the blind cavity and a surface of the substrate.
Example 4 provides the substrate of any of examples 1-2, in which the cavity is through a thickness of the core.
Example 5 provides the substrate of example 4, in which the IC die comprises TSVs configured to electrically couple a surface of the substrate and an opposing surface of the substrate.
Example 6 provides the substrate of example 5, in which the conductive traces comprise vias between the TSVs and the surface of the substrate and between the TSVs and the opposing surface of the substrate.
Example 7 provides the substrate of any of examples 1-6, in which the IC die is attached to the core in the cavity with an adhesive.
Example 8 provides the substrate of any of examples 1-7, in which the dielectric comprises a solder resist material or ABF.
Example 9 provides the substrate of any of examples 1-8, in which the conductive traces comprise copper.
Example 10 provides the substrate of any of examples 1-9, in which the conductive traces comprise layers of metal through the dielectric and conductive vias coupling the layers.
Example 11 provides the substrate of example 10, in which at least one layer comprises a seed layer in contact with the core.
Example 12 provides the substrate of example 11, in which the seed layer comprises titanium and copper.
Example 13 provides the substrate of any of examples 10-12, in which the conductive traces further comprise conductive pads on exposed surfaces of the substrate configured to couple to another IC die or another substrate.
Example 14 provides the substrate of example 13, in which the conductive pads on one exposed surface comprises copper pillars configured to form hybrid direct bonds with another IC die and the conductive pads on another exposed surface comprises bond pads configured for flip-chip bumps.
Example 15 provides the substrate of any of examples 1-14, further comprising conductive vias through the dielectric on either side of the core electrically coupling the TGV with a first exposed surface (*e.g*., 116) of the substrate and an opposite second exposed surface (*e.g*., 120) of the substrate.
Example 16 provides a microelectronic assembly (*e.g*., 100 of FIG. 1) comprising: a substrate (*e.g*., 102) having a core (*e.g*., 104) comprised of glass; and a first IC die (*e.g*., 112) and a second IC die (*e.g*., 114) coupled to a first side (*e.g*., 116) of the substrate. The core comprises a cavity (*e.g*., 106), a third IC die (*e.g*., 108) is located within the cavity, and the core further comprises one or more conductive TGV (*e.g*., 118) that facilitates electrical coupling between the first side of the substrate and an opposing second side (*e.g*., 120) of the substrate.
Example 17 provides the microelectronic assembly of example 16, in which the substrate further comprises dielectric and conductive traces on either side of the core.
Example 18 provides the microelectronic assembly of example 17, in which the dielectric comprises solder resist or ABF.
Example 19 provides the microelectronic assembly of any of examples 17-18, in which the conductive traces comprise layers of metal in the dielectric and conductive vias between the layers.
Example 20 provides the microelectronic assembly of any of examples 17-19, in which the third IC die is electrically coupled to the conductive traces with interconnects (*e.g*., 204).
Example 21 provides the microelectronic assembly of any of examples 17-20, in which the conductive traces comprise vias electrically coupling the TGVs to the first side and the second side.
Example 22 provides the microelectronic assembly of any of examples 16-21, in which the third IC die provides electrical coupling between the first IC die and the second IC die.
Example 23 provides the microelectronic assembly of any of examples 16-21, in which the third IC die does not provide electrical coupling between the first side of the substrate and the second side of the substrate.
Example 24 provides the microelectronic assembly of any of examples 16-22, in which: the third IC die comprises a third side proximate to the first side and an opposing fourth side proximate to the second side, and the third IC die comprises a TSV providing electrical coupling between the third side and the fourth side.
Example 25 provides the microelectronic assembly of example 24, in which: the cavity is a blind cavity, and the core comprises another TGV (*e.g*., 320) providing electrical coupling between the blind cavity and the second side.
Example 26 provides the microelectronic assembly of example 24, in which the cavity goes through an entire thickness of the core.
Example 27 provides the microelectronic assembly of any of examples 16-26, in which the first IC die is different from the second IC die in at least one functionality.
Example 28 provides the microelectronic assembly of any of examples 16-27, in which the first IC die and the second IC die are coupled to the substrate with FLI.
Example 29 provides the microelectronic assembly of example 28, in which the FLI comprise hybrid direct bonds or flip-chip bumps.
Example 30 provides the microelectronic assembly of any of examples 28-29, in which the substrate is configured to be coupled to a component on the second side with MLI or SLI.
Example 31 provides the microelectronic assembly of example 30, in which a first pitch of the MLI is larger than a second pitch of the FLI and smaller than a third pitch of the SLI.
Example 32 provides the microelectronic assembly of example 30, in which a first pitch of the MLI is same as a second pitch of the FLI.
Example 33 provides the microelectronic assembly of any of examples 30-32, in which the component comprises another substrate, another IC die, or a silicon interposer.
Example 34 provides the microelectronic assembly of any of examples 16-33, further comprising mold compound encapsulating the first IC die and the second IC die.
Example 35 provides the microelectronic assembly of any of examples 16-34, in which the third IC die is attached inside the cavity with an adhesive.
Example 36 provides a method for forming a substrate of a microelectronic assembly, the method comprising: forming a cavity in a panel comprising glass; placing an IC die in the cavity; encapsulating the IC die with a dielectric; and forming alternating layers of the dielectric and metal layers on either side of the panel to form the substrate.
Example 37 provides the method of example 36, in which forming the cavity comprises LIDE by laser sensitizing the panel and etching with hydrofluoric acid to remove the sensitized material.
Example 38 provides the method of example 37, in which forming the cavity further comprises using at least one TGV in the panel as a fiducial mark to align the cavity on the panel.
Example 39 provides the method of example 38, in which placing the IC die comprises using the fiducial mark for aligning the IC die within the cavity.
Example 40 provides the method of any of examples 36-39, in which forming the alternating layers comprises patterning conductive traces in the metal layers.
Example 41 provides the method of any of examples 36-40, in which the dielectric comprises ABF or solder resist.
Example 42 provides the method of any of examples 36-41, in which encapsulating the IC die comprises vacuum forming or pressing the dielectric to conform to a space around the IC die in the cavity.
Example 43 provides the method of any of examples 36-42, further comprising: forming through-holes in the panel; depositing a conductive seed layer on the panel such that the conductive seed layer coats side walls of the through-holes; depositing conductive metal within the through-holes to form TGVs; and planarizing a surface of the panel to remove excess conductive metal in the TGVs.
Example 44 provides the method of example 43, in which forming through-holes comprises performing LIDE on the panel.
Example 45 provides the method of any of examples 43-44, in which depositing the conductive seed layer comprises sputtering titanium and copper on the panel.
Example 46 provides the method of any of examples 43-45, in which depositing conductive metal comprises electroplating copper on the panel having the seed layer.
Example 47 provides the method of any of examples 36-46, further comprising forming conductive vias in the dielectric coupling the metal layers and conductive contacts on the surfaces of the substrate.
Example 48 provides the method of any of examples 36-47, in which forming alternating layers of dielectric and metal layers on either side of the panel comprises: forming alternating layers of dielectric and metal layers on one side of the panel; attaching a protective cap on a surface of the layers; and inverting the panel such that another side opposite to the side is exposed for further processing.
Example 49 provides the method of example 48, further comprising forming alternating layers of the dielectric and metal layers on the another side.
Example 50 provides the method of example 48, further comprising: coupling another IC die to bond pads on the exposed surface; and dicing the assembly into individual microelectronic assemblies.
Example 51 provides the method of example 50, further comprising encapsulating the another IC die with a mold compound.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

## Claims

1. A substrate for a microelectronic assembly comprising:
a core including glass and dielectric and conductive traces on either side of the core, wherein:
the core includes a cavity configured to seat an integrated circuit, IC, die, and
the core further includes one or more conductive through-glass via, TGV, through the core.

2. The substrate of claim 1, wherein the cavity is one of: a blind cavity and a cavity through a thickness of the core.

3. The substrate of claim 2, wherein the cavity is a blind cavity, the substrate further comprising another TGV through the core between the blind cavity and a surface of the substrate.

4. The substrate of claim 2, wherein:
the cavity is a blind cavity,
the IC die comprises through-substrate vias, TSVs, configured to electrically couple a surface of the substrate and an opposing surface of the substrate, and
the conductive traces comprise vias between the TSVs and the surface of the substrate and between the TSVs and the opposing surface of the substrate.

5. The substrate of any of claims 1, wherein:
the cavity is a blind cavity, and
the IC die is attached to the core in the cavity with an adhesive.

6. The substrate of any of claims 1-5, wherein:
the conductive traces comprise layers of metal through the dielectric and conductive vias coupling the layers,
the conductive traces further comprise conductive pads on exposed surfaces of the substrate configured to couple to another IC die or another substrate, and
the conductive pads on one exposed surface comprises copper pillars configured to form hybrid direct bonds with another IC die and the conductive pads on another exposed surface comprises bond pads configured for flip-chip bumps.

7. The substrate of any of claims 1-6, further comprising conductive vias through the dielectric on either side of the core electrically coupling the TGV with a first exposed surface of the substrate and an opposite second exposed surface of the substrate.

8. A microelectronic assembly comprising the substrate as claimed in any one of claims 1-7, the microelectronic assembly further comprising:
a first IC die and a second IC die coupled to a first side of the substrate,
wherein:
the substrate has a core comprised of glass,
the core comprises a cavity,
a third IC die is located within the cavity, and
the core further comprises one or more conductive TGV that facilitates electrical coupling between the first side of the substrate and an opposing second side of the substrate.

9. The microelectronic assembly of claim 8, wherein:
the third IC die comprises a third side proximate to the first side and an opposing fourth side proximate to the second side, and
the third IC die comprises a TSV providing electrical coupling between the third side and the fourth side.

10. The microelectronic assembly of claim 9, wherein:
the cavity is a blind cavity, and
the core comprises another TGV providing electrical coupling between the blind cavity and the second side.

11. The microelectronic assembly of claim 9, wherein the cavity goes through an entire thickness of the core.

12. The microelectronic assembly of any of claims 8-11, wherein:
the first IC die and the second IC die are coupled to the substrate with FLI, and
the substrate is configured to be coupled to a component on the second side with MLI or SLI.

13. A method for forming a substrate of a microelectronic assembly, the method comprising:
forming a cavity in a panel comprising glass;
placing an IC die in the cavity;
encapsulating the IC die with a dielectric; and
forming alternating layers of the dielectric and metal layers on either side of the panel to form the substrate.

14. The method of claim 13, wherein forming the cavity comprises laser induced direct etching, LIDE, by laser sensitizing the panel and etching with hydrofluoric acid to remove the sensitized material.

15. The method of any of claims 13-14, further comprising:
forming through-holes in the panel;
depositing a conductive seed layer on the panel such that the conductive seed layer coats side walls of the through-holes;
depositing conductive metal within the through-holes to form TGVs; and
planarizing a surface of the panel to remove excess conductive metal in the TGVs.
